(19) Europäisches Patentamt
European Patent Office
Office européen des brevets

(11) **EP 2 156 554 B1**

(12) **FASCICULE DE BREVET EUROPEEN**

(45) Date de publication et mention
de la délivrance du brevet:
**20.03.2013 Bulletin 2013/12**

(51) Int Cl.:
***H03H 9/02*** *(2006.01)* ***H03H 9/64*** *(2006.01)*

(21) Numéro de dépôt: **08761145.5**

(86) Numéro de dépôt international:
**PCT/EP2008/057681**

(22) Date de dépôt: **18.06.2008**

(87) Numéro de publication internationale:
**WO 2008/155346 (24.12.2008 Gazette 2008/52)**

(54) **RESONATEUR A ONDES DE SURFACE A RESONANCE PARASITE REDUITE**

OBERFLÄCHENWELLENRESONATOR MIT VERMINDERTER STÖRRESONANZ

SURFACE WAVE RESONATOR HAVING REDUCED PARASITIC RESONANCE

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité: **19.06.2007 FR 0704363**

(43) Date de publication de la demande:
**24.02.2010 Bulletin 2010/08**

(73) Titulaire: **Senseor**
**06560 Valbonne (FR)**

(72) Inventeurs:
• **BALLANDRAS, Sylvain**
**F-25000 Besancon (FR)**
• **PENAVAIRE, Louis**
**F-06300 Nice (FR)**
• **PASTUREAUD, Thomas**
**F-06410 Biot (FR)**

(74) Mandataire: **Esselin, Sophie et al**
**Marks & Clerk France**
**Conseils en Propriété Industrielle**
**Immeuble Visium**
**22, Avenue Aristide Briand**
**94117 Arcueil Cedex (FR)**

(56) Documents cités:
**EP-A- 1 003 286      EP-A2- 1 542 361**
**DE-A1- 10 236 003      FR-A- 2 864 618**
**US-A- 4 642 506**

**Description**

L'invention se rapporte à un résonateur à ondes de surface optimisé dans lequel les résonances parasites en début et sortie de bande passante sont fortement atténuées.

De manière générale, les composants à ondes de surface sont généralement bien connus et utilisés dans le domaine du traitement du signal, et principalement dans le filtrage de bande, avec des possibilités de fréquence centrale, de bande passante, de fonctions de transfert très diverses.

Pour minimiser les variations des caractéristiques liées à la température ambiante, aux contraintes mécaniques, aux pollutions, ainsi qu'aux variations de la nature chimique de la surface du composant, on cherche à réaliser des composants sur des substrats dont les variations des propriétés physiques avec la température sont aussi faibles que possible. On utilise des colles et des supports du substrat sur lequel est réalisé le composant qui amènent le moins de contraintes possibles. La plupart de ces composants sont encapsulés dans des boîtiers hermétiques, dans une atmosphère neutre, de sorte qu'aucune pollution ne puisse se déposer sur le substrat et en particulier sur les électrodes d'excitation/détection des ondes, et qu'aucune altération chimique ne puisse intervenir.

En revanche, la sensibilité de la vitesse de propagation des ondes de surface à différentes influences extérieures est un atout dans le cadre de la réalisation de capteurs. La possibilité d'utiliser ainsi les composants à ondes de surface est apparue pratiquement dès le début de leur utilisation. Mais ces dernières années, plusieurs applications ont commencé à se concrétiser. Aujourd'hui ils sont utilisés aussi bien dans des capteurs de température que de contrainte, de pression, de couple ou bien encore de grandeurs chimiques.

Un des premiers avantages de ces capteurs est qu'ils peuvent être interrogés à distance de façon passive. Dans ce cas, le capteur à ondes de surface est relié à une antenne qui reçoit le signal d'interrogation. Ce qui est ré-émis par l'antenne va donc dépendre du coefficient de réflexion électrique du composant $S_{11}$. Dans le cas d'applications plus classiques où le composant est utilisé, par exemple dans une boucle d'oscillation, on considère plutôt sa fonction de transfert électrique $S_{21}$. Dans le cas d'une interrogation à distance, les caractéristiques accessibles sont le plus fréquemment le retard du signal d'interrogation introduit par le composant à ondes de surface ou la fréquence centrale du composant. Aussi bien le retard que la fréquence centrale sont directement liés à la vitesse de propagation des ondes de surface sur le substrat. Cette vitesse est plus ou moins sensible à la température, aux contraintes appliquées au substrat, aux matériaux déposés à la surface ainsi qu'à leur nature chimique selon la conception du capteur correspondant.

Dans le cas où l'on souhaiterait déterminer la grandeur à mesurer par une mesure de fréquence, il faut choisir un type de dispositif dont la fréquence centrale puisse être déterminée de façon précise. On utilise généralement des résonateurs qui lorsqu'ils sont conçus suivant les règles de l'art présentent des surtensions élevées donc propres à une détermination précise de la fréquence. De plus, les résonateurs présentent l'avantage par rapport aux autres structures à ondes de surface d'avoir des dimensions beaucoup plus faibles à performances identiques. Ainsi, un résonateur à 433 MHz, réalisé sur quartz, ayant une surtension de 10000 a une longueur typique comprise entre 2.5 mm et 3 mm, alors que si on souhaitait obtenir la même bande avec une ligne à retard, sa longueur serait 15 fois plus importante. D'autre part, la possibilité de pouvoir interroger ces composants à distance, si elle est un avantage, impose aussi quelques contraintes dans le cas où les capteurs seraient dans des environnements non clos électromagnétiquement car il faut alors que les fréquences émises respectent les bandes ISM (Industrielles, Scientifiques et Médicales). On constate que la plupart de ces bandes ISM sont étroites, ce qui constitue une raison supplémentaire d'utilisation de résonateurs préférentiellement à d'autres types de composants à ondes de surface.

Les résonateurs à ondes de surface peuvent a priori être réalisés sur tout type de substrat piézoélectrique permettant la génération et la propagation des ondes de surface, les plus couramment utilisés de ces matériaux étant le quartz, le tantalate de lithium et le niobate de lithium. Pour chacun de ces matériaux, plusieurs coupes sont utilisables.

Le quartz avec différentes coupes cristallines possibles, est le plus stable en température de tous ces matériaux. Les plus connues de ces coupes sont les coupes Y tournées autour de l'axe X d'un angle compris entre 32° et 42°45' (la coupe ST) ; ces coupes ont une variation parabolique de la fréquence avec la température : (par exemple de type , $f(T) - f(T_0))/f(T_0) = 3 \times 10^{-8} \times (T - T_0)^2$, le facteur $3 \times 10^{-8}$ pouvant être plutôt $4 \times 10^{-8}$ selon les colles utilisées , la température $T_0$ dépendant de l'angle de coupe (étant une température de référence généralement égale à 25°C) ,de la fréquence de travail ainsi que des paramètres de fabrication du produit. Le matériau qui présente le coefficient de température le plus élevé est le niobate de lithium - coupe Y et propagation suivant Z - pour laquelle le coefficient de température est de -90 ppm/°C (compris entre -80 et -100 ppm selon l'orientation choisie). Lorsqu'on est tenu de respecter les bandes de fréquence ISM, le seul matériau utilisable est le quartz afin que les fréquences des composants utilisés ne sortent pas des bandes ISM dans les conditions usuelles de température d'utilisation (-20/+80°C).

D'autre part, lorsque les grandeurs à mesurer sont autres que des températures (contraintes par exemple), il faut que les variations de fréquence en température soient de préférence inférieures à celles induites par la grandeur à mesurer. Il en résulte que là encore le quartz est souvent le seul matériau utilisable pour de telles applications.

Il faut aussi remarquer que quelle que soit la grandeur à laquelle on veut accéder, et quel que soit le matériau utilisé, la fréquence de résonance d'un résonateur ou le retard d'une ligne à retard ne sont pas seulement affectés par la grandeur à mesurer. Il faut donc en général disposer sur le capteur plusieurs résonateurs ou implanter plusieurs retards, de façon à pouvoir établir l'influence de chaque paramètre. Ainsi, si l'on veut mesurer une pression (par la contrainte qui peut en résulter), il faut pouvoir déterminer la température.

Dans le cas d'un capteur de température, on est donc amené à disposer sur le capteur, deux résonateurs ayant des comportements en température différents afin d'éliminer les variations de fréquence corrélées, liées à d'autres phénomènes (dérive de fréquence au cours du temps par exemple). Pour mesurer une pression, il faut trois résonateurs sur le même substrat (donc à la même température) : un seul des trois résonateurs est soumis à la contrainte résultant de la pression à mesurer, un des deux autres résonateurs doit avoir le même comportement en température que celui qui mesure la pression, le troisième résonateur enfin doit avoir un comportement en température différent de celui des deux autres.

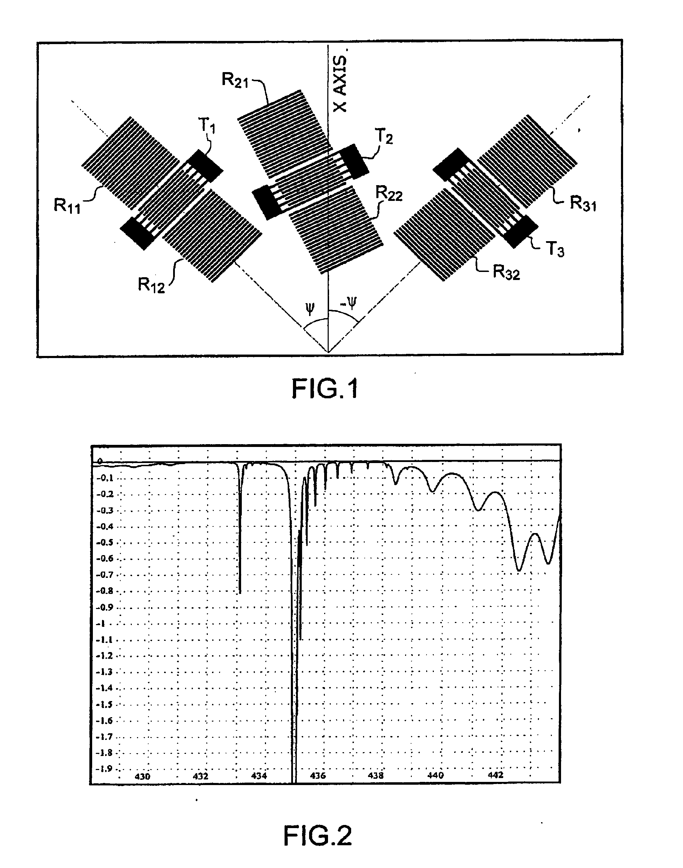

On retrouve cette configuration pour des capteurs de couple comme représenté schématiquement à la figure 1 et comprenant trois résonateurs constitués chacun d'un transducteur $T_1$, $T_2$, $T_3$ compris chacun entre un couple de réseaux réflecteurs $R_{11}$, $R_{12}$, $R_{21}$, $R_{22}$, $R_{31}$, $R_{32}$.

Ainsi, on est facilement amené à devoir interroger un ensemble de trois résonateurs dont les fréquences de résonance sont peu différentes en raison des limitations imposées par le respect des bandes ISM, mais aussi pour des raisons pratiques (largeur de la bande de fréquence à balayer).

Lorsque l'on est amené à concevoir de tels résonateurs, un certain nombre de difficultés apparaissent nécessitant de répondre à plusieurs contraintes :

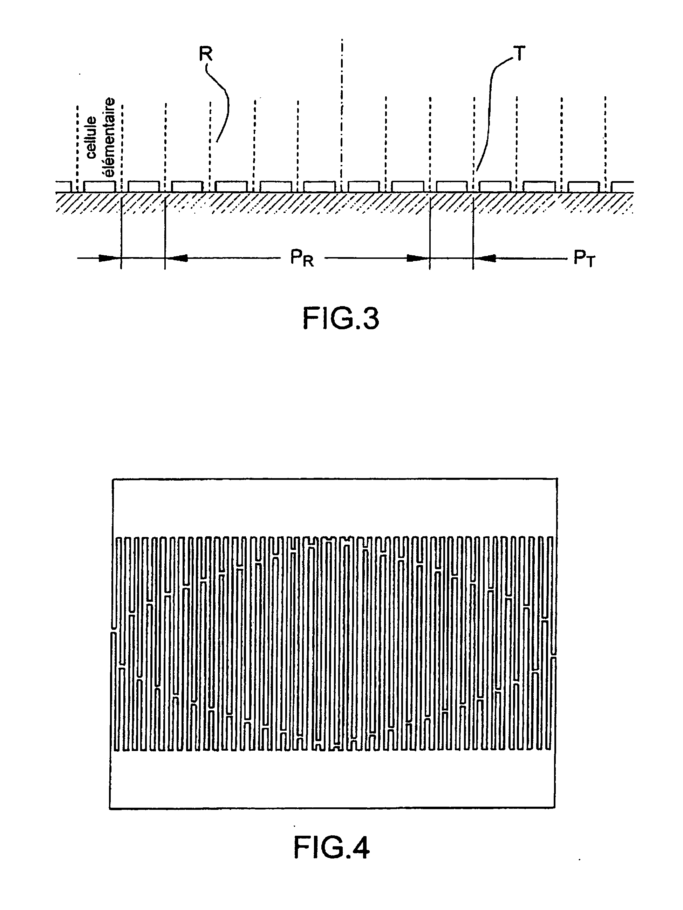

- faible encombrement pour obtenir un composant de faibles dimensions et donc de faible coût,
- impédance de chacun des résonateurs adaptée à celle de l'antenne qui capte le signal d'interrogation afin d'assurer la meilleure efficacité possible au système,
- surtension des résonateurs aussi élevée que possible, garantissant la meilleure résolution en fréquence possible et donc la sensibilité du capteur,
- résonance de chacun des résonateurs non perturbée par les autres résonateurs. Cette dernière contrainte n'est pas aisée à respecter car les fréquences de résonance sont peu écartées, et les résonateurs à ondes de surface, par leur conception, présentent des variations d'impédance en fonction de la fréquence autres que celles liées à la résonance souhaitée susceptibles de perturber les résonances des résonateurs voisins et fausser ainsi les fréquences mesurées comme illustrées en figure 3.

A ce jour, il existe de nombreuses façons de concevoir des résonateurs à ondes de surface. Il existe notamment des structures d'un résonateur à ondes de surface de type synchrone ou proche d'un type synchrone à 2 traits/λ (dits asynchrones). Dans un résonateur de type synchrone, réflecteurs et transducteur sont constitués de traits ou électrodes métalliques déposés sur le substrat et qui présentent la même périodicité mécanique. Il n'y a dans la structure aucune rupture de cette périodicité. On peut définir une cellule comme étant la zone centrée sur l'axe d'un trait et dont la largeur est égale à la période des réflecteurs et/ou électrodes. Dans un résonateur synchrone, toutes les cellules (réflectrices ou transductrices) sont jointives. Dans un résonateur dit asynchrone, la périodicité $P_T$ des électrodes du transducteur T est légèrement différente (inférieure) de celle $P_R$ des réflecteurs R, afin d'obtenir une fréquence de résonance centrée dans la bande d'arrêt des réflecteurs. Cependant, toutes les cellules sont toujours jointives. Il n'y a pas de séparation (ou décalage) entre les réflecteurs et le transducteur (comme illustré en figure 2).

Dans tous les cas, on cherche à réaliser une cavité résonante pour les ondes de surface, dont les réflecteurs sont constitués de réseaux de traits métallisés ou gravés dans le substrat, ces réflecteurs ayant chacun un faible coefficient de réflexion (de l'ordre du % à quelques 10% selon les configurations d'électrode). A la fréquence à laquelle toutes les réflexions sont en phase (c'est à dire celle pour laquelle la périodicité des réflecteurs est égale à une demi-longueur d'onde, encore appelée condition de Bragg), le coefficient de réflexion est maximum, et si le nombre de réflecteurs élémentaires est suffisamment grand, ce coefficient de réflexion est pratiquement égal à 1.

Le couplage électrique avec la cavité résonante se fait en plaçant un ou deux transducteurs dans la cavité résonante. Les transducteurs peuvent avoir des périodes très différentes de celles des réflecteurs (3 traits ou 4 traits par longueur d'onde) ; ils sont alors transparents pour les ondes de surface et leurs caractéristiques (nombre d'électrodes, ouverture acoustique) n'interviennent que sur la valeur de la résistance à la résonance. En revanche, ils peuvent aussi avoir une périodicité d'électrode égale ou proche de celle des réflecteurs. Dans ce cas, les électrodes des transducteurs participent au coefficient de réflexion total, et cela offre l'avantage de pouvoir obtenir une cavité résonante de meilleure qualité sans avoir à augmenter la longueur des réflecteurs.

De manière générale, l'ouverture acoustique du transducteur (la longueur de recouvrement entre deux doigts de polarité opposée) est avantageusement pondérée en arc cosinus. Cette pondération des longueurs d'électrode est représentée en figure 4. En effet, si une telle configuration n'est pas respectée, on constate la présence de plusieurs résonances parasites dues à des modes transversaux. La présence de bus auxquels sont reliés les doigts du transducteur induit des conditions de résonance également selon son ouverture acoustique. Si l'ouverture est constante selon la longueur du transducteur, les conditions de synchronisme sont réunies pour le piégeage d'énergie de ces modes transversaux qui ne sont ni plus ni moins que les multiples modalités de résonance et de piégeage de l'onde de Rayleigh. Leur nombre et leur amplitude dépendent de l'épaisseur et du taux de métallisation ainsi que de l'ouverture acoustique. La pondération de l'ouverture du transducteur suivant une loi en arc cosinus assure un bon couplage avec le premier mode (la résonance principale), mais défavorise celui des modes transversaux d'ordre supérieur.

En parallèle de l'utilisation des coupes de matériaux piézoélectriques mono-cristallins (généralement du quartz de coupe ST ou proche de cette coupe), et avec un axe de propagation (l'axe X pour le quartz ST) pour lequel la directivité est nulle, le développement d'applications capteurs exploitant des résonateurs à ondes de surface a poussé à l'utilisation d'autres axes de propagation que l'axe X sur les coupes de quartz usuelles, axes pour lesquels la directivité n'est pas nulle. Cependant l'utilisation de ces coupes présentant des directivités non nulles peut amener l'apparition de résonances parasites pénalisantes pour beaucoup d'applications capteurs exploitant des résonateurs à ondes de surface car interférant avec la résonance principale d'un des autres résonateurs nécessaires au fonctionnement du capteur.

Le document FR2864618 concerne un capteur de température à ondes acoustiques de surface comprenant un premier, deuxième et troisième résonateur constitué chacun d'un transducteur placé entre deux réseaux réflecteurs et disposés sur un substrat.

C'est pourquoi pour résoudre ce problème de résonance parasite, la présente invention concerne un nouveau type de résonateur à ondes de surface sur quartz ou tout autre matériau et coupe présentant une directivité naturelle ($LiTaO_3$, $LiNbO_3$, langasite, $GaPO_4$, $LiB_4O_7$, $KNbO_3$, AIN, GaN, ZnO, ces trois derniers matériaux étant souvent exploités sous forme de films minces, etc.)., dans lequel la résonance parasite en début ou en sortie de bande d'arrêt, en plus de la résonance souhaitée, est fortement atténuée et notamment lorsqu'un tel résonateur est réalisé par exemple sur des coupes de quartz avec des axes de propagation pour lesquels il existe une directivité naturelle. Plus précisément, la présente invention a pour objet un résonateur à ondes acoustiques de surface, selon la revendication indépendante, réalisé sur un substrat de coupe avec des axes de propagation pour lesquels il existe une directivité non nulle et comportant au moins un transducteur central présentant un axe central, un premier réseau de réflecteurs et un second réseau de réflecteurs, lesdits réseaux étant situés de part et d'autre dudit transducteur caractérisé en ce que les deux réseaux de réflecteurs présentent des configurations non symétriques par rapport à l'axe central dudit transducteur central, le premier et/ou le second réseaux de réflecteurs présentant sur une portion d'unités de réflecteurs, une variation de périodes desdits réflecteurs.

Selon une variante de l'invention, le premier réseau de réflecteurs présentant une première distance de séparation par rapport au transducteur, le second réseau de réflecteurs présentant une seconde distance de séparation par rapport au transducteur, les première et seconde distances de séparation correspondant respectivement à la distance entre une extrémité du premier réseau de réflecteurs et une première extrémité du transducteur et à la distance séparant une extrémité du second réseau de réflecteurs et la seconde extrémité du transducteur, lesdites distances de séparation sont différentes.

Selon une variante de l'invention, le premier et/ou le second réseau de réflecteurs comporte une centaine (c'est un ordre de grandeur, mais cela peut être plusieurs centaines) de réflecteurs et présente sur environ une dizaine à une vingtaine d'unités de réflecteurs, une variation de périodes desdits réflecteurs.

Avantageusement, la variation de période est d'environ 1%. Cette variation permet d'éviter des variations trop brutales de la période (qui pourraient être néfastes au bon fonctionnement du résonateur). On répartit avantageusement l'amplitude de la séparation réseau-transducteur, nécessaire pour atténuer la résonance parasite, sur le nombre de réflecteurs que l'on choisit.

Selon une variante de l'invention, la période des réseaux réflecteurs étant de l'ordre de 3,5 microns (pour une application à 433 MHz uniquement), la variation de période par rapport à ladite période est de quelques dizaines de nanomètres.

Selon une variante de l'invention, les réflecteurs étant constitués de traits métalliques, la première série et/ou la seconde série de réflecteurs présente sur une portion d'unités de réflecteurs, une variation d'épaisseur desdits traits.

Selon une variante de l'invention, les réflecteurs étant constitués de traits métalliques, la première série et/ou la seconde série de réflecteurs présente sur une portion d'unités de réflecteurs, une variation de nature de métal.

Selon une variante de l'invention, les réflecteurs étant constitués de traits métalliques passivés (c'est à dire recouvert d'une couche diélectrique, comme par exemple la silice $SiO_2$, les oxy-nitrures de silicium, l'oxyde de titane $TiO_2$, etc.) pour des raisons d'immunité à la pollution évoquées en introduction, l'épaisseur de passivation varie au long du réseau de réflecteurs ou la passivation peut éventuellement changer de nature.

L'invention sera mieux comprise et d'autres avantages apparaîtront à la lecture de la description qui va suivre donnée à titre non limitatif et grâce aux figures annexées parmi lesquelles :

- la figure 1 illustre un capteur de couple selon l'art connu comportant trois résonateurs ;
- la figure 2 illustre l'évolution du coefficient de réflexion pour un résonateur sur quartz en fonction de la fréquence et présentant des résonances secondaires indésirables ;

- la figure 3 illustre un exemple de structure de résonateur dans laquelle le réseau de réflecteurs et le transducteur sont jointifs ;
- la figure 4 illustre l'ouverture acoustique d'un exemple de transducteur pondérée en arc cosinus ;
- les figures 5a et 5b illustrent un premier exemple de résonateur selon l'invention comprenant un décalage de distance des séries de réseaux réflecteurs de part et d'autre du transducteur central ;
- la figure 6 illustre un exemple d'évolution du coefficient de réflexion et de la directivité en fonction de la direction de propagation dans un résonateur selon l'invention ;
- les figures 7a, 7b et 7c illustrent les spectres de résonance (le module du coefficient de réflexion du dispositif $S_{11}$) respectivement pour un exemple de résonateur sur quartz de coupe Y+34°, propagation sur X+30°, respectivement, avec une symétrie des réseaux réflecteurs par rapport à l'axe central $A_T$, avec des décalages de part et d'autre du transducteur, avec un seul décalage d'un des réseaux réflecteurs par rapport au transducteur.

De façon générale, le résonateur de l'invention comporte au moins un transducteur central et deux réseaux de réflecteurs de part et d'autre dudit transducteur. Le transducteur et les réseaux réflecteurs sont typiquement réalisés par dépôts de traits métalliques sur un substrat piézoélectrique.

Selon l'invention, il est introduit une dissymétrie progressive et douce au niveau des réflecteurs de part et d'autre du transducteur central de manière à minimiser les pertes.

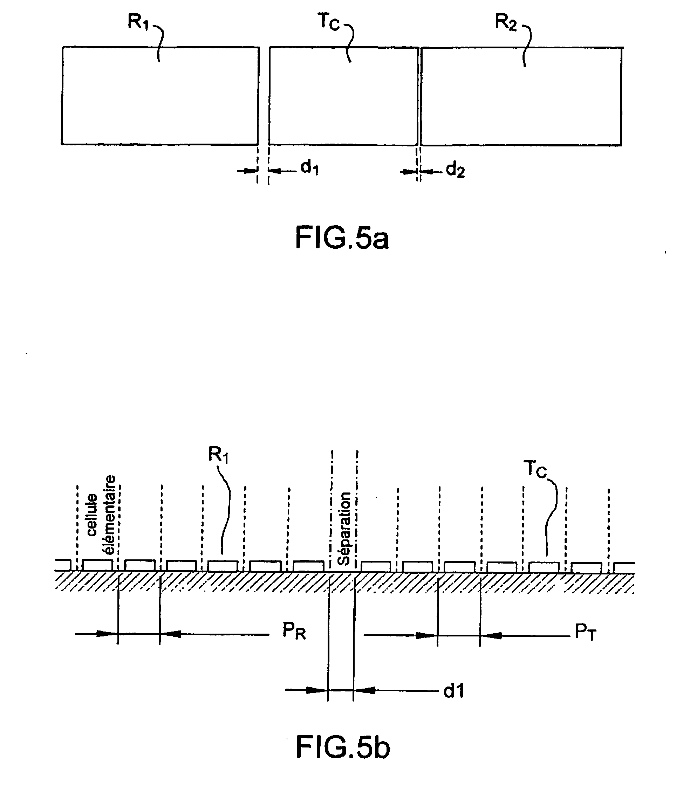

Selon une première variante de l'invention illustrée en figures 5a et 5b, il est introduit des décalages entre le transducteur $T_c$ et les deux réseaux réflecteurs $R_1$ et $R_2$). La distance entre la cellule correspondant à un réflecteur, la plus à droite du réseau réflecteur de gauche et la cellule la plus à gauche du transducteur est $d_1$. La distance entre la cellule la plus à droite du transducteur et la cellule la plus à gauche du réseau réflecteur de droite est $d_2$. Dans le cas d'une directivité nulle, on doit avoir $d_1 = d_2 = 0$. Typiquement les distances $d_1$ et $d_2$ séparant les réseaux réflecteurs $R_1$ et $R_2$ du transducteur sont inférieures à une demi-longueur d'onde et sont donc de valeurs différentes d'un côté ou de l'autre du transducteur et dépendent de la valeur de la directivité.

Ainsi, pour éviter la présence de modes indésirables en début ou en fin de bande d'arrêt (selon la configuration choisie), une variante de l'invention consiste à introduire des séparations entre chacun des réseaux et le transducteur, ces séparations étant d1 et d2

$$d_1 = \lambda_0 \times (\delta / 2 / 360)$$

et celui de l'autre côté étant $d_2$ avec :

$$d_2 = \lambda_0 \times [(180 - \delta / 2) / 360]$$

Par exemple, pour une longueur d'onde de 7.5 μm et une directivité de 50°, on obtient :

$$d_1 = 0.52 \ \mu m$$

$$d_2 = 3.23 \ \mu m$$

$\delta$ étant la directivité en degrés (valeur positive ou négative) dépendant de la coupe de matériau considérée et de la configuration des électrodes.

Il est donc nécessaire pour cela de déterminer la directivité $\delta$.

Pour déterminer la directivité $\delta$, il faut utiliser un modèle donnant accès aux caractéristiques de propagation de l'onde sous un réseau d'électrodes, le modèle dit FEM/BEM harmonique et périodique permettant d'estimer les propriétés des ondes de type Rayleigh dans de telles conditions (ce modèle permet de caractériser les propriétés de tout type d'onde guidée). On suppose que le transducteur est périodique et l'on caractérise les propriétés de l'onde acoustique qui se propage sous le réseau d'électrodes. Le modèle étant périodique, on fixe le matériau et son orientation, et les propriétés de l'onde ne dépendent plus alors que de deux paramètres géométriques indépendants :

- le taux de métallisation, c'est à dire, le rapport entre la largeur a de l'électrode et la période *p* du réseau (rapport a/p) ;
- la hauteur de métallisation relative, c'est à dire, la hauteur de l'électrode normalisée par la période ou un multiple de la période en fonction de l'excitation électrique imposée ;
- la forme de l'électrode, bien que susceptible de conditionner les caractéristiques de réflexion de l'onde, est souvent idéalisée sous forme de rectangle (modification des propriétés des ondes de quelques %) ;

En tenant compte des paramètres suivants :

- type du substrat piézoélectrique,
- angle de coupe $\theta$,
- direction de propagation $\psi$,
- taux de métallisation a/p,
- hauteur de métallisation h/$\lambda$,

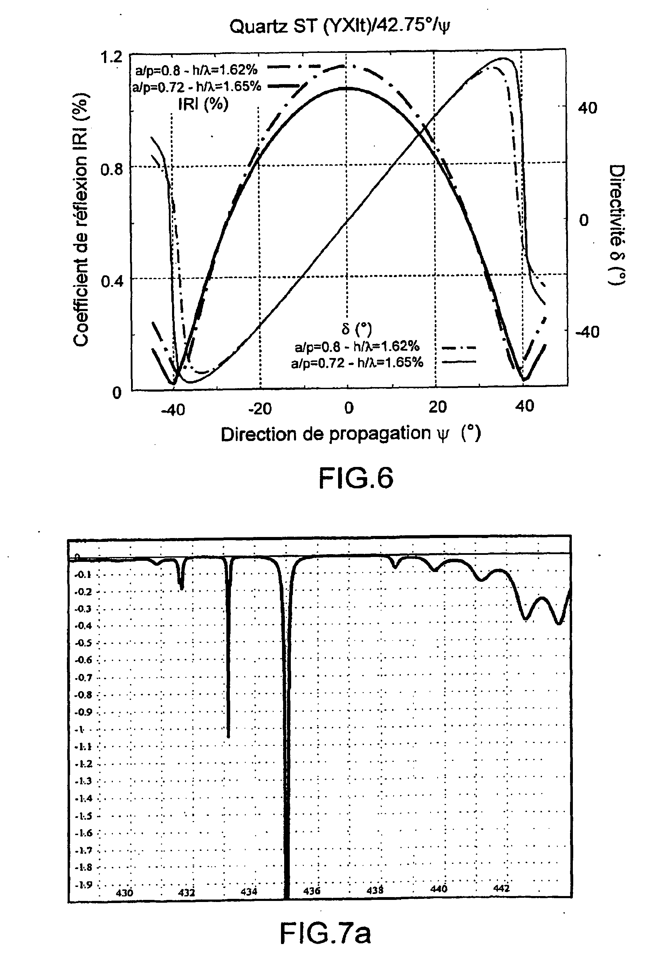

on est en mesure de déterminer le coefficient de réflexion et la directivité, en fonction de la direction de propagation comme illustrée en figure 6.

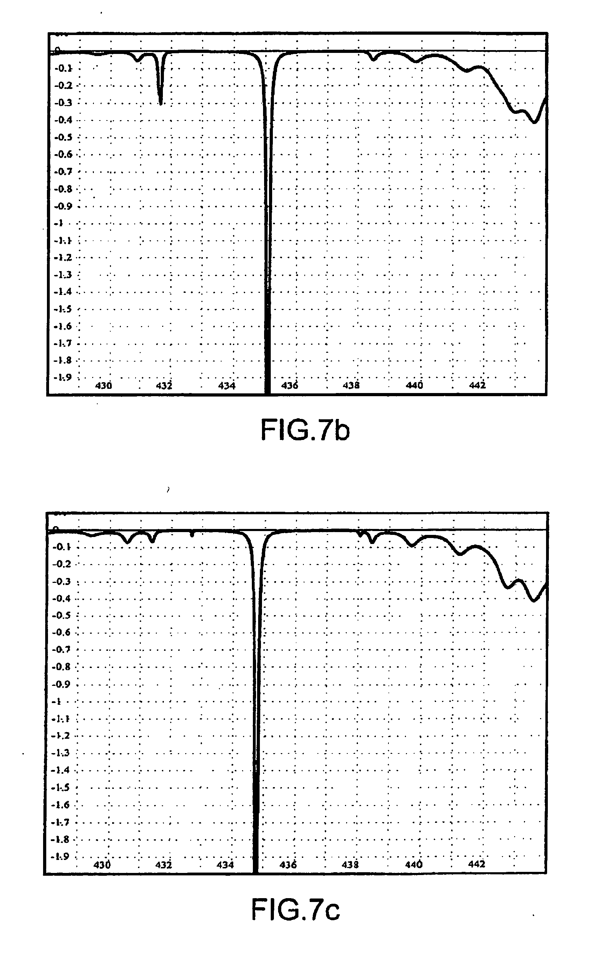

A titre de validation, les figures 7a, 7b et 7c illustrent les spectres de résonance pour un exemple de résonateur sur quartz de coupe Y+34°, propagation sur X+30°, respectivement avec une symétrie des réseaux réflecteurs par rapport à l'axe central $A_T$, avec des décalages de part et d'autre du transducteur et avec un seul décalage.

Selon l'invention, le résonateur comporte deux réseaux de réflecteurs comportant localement une variation de période des réflecteurs sur quelques unités. Ainsi localement les périodes $P_{r1}$ et /ou $P_{r2}$ sont localement modifiées. Si localement la période est augmentée, cela revient à avoir un décalage positif. Si c'est l'inverse, le décalage et négatif.

Typiquement pour un résonateur fonctionnant à 433 MHz, lorsque la période est de l'ordre de 3,5 microns pour des réseaux réflecteurs comportant une centaine de traits métalliques environ, la période sur une dizaine de traits peut être modifiée et ce avec une variation de quelques dizaines de nanomètres. La période du transducteur diffère de celle des réseaux de quelques dizaines de nanomètres également (de l'ordre de 1% de la période)

Selon une variante de l'invention, les réflecteurs étant constitués de traits métalliques, la première série et/ou la seconde série de réflecteurs présente sur une portion d'unités de réflecteurs, une variation d'épaisseur desdits traits. Typiquement on peut se référer à la figure 6, où apparaît la variation de directivité induite par une variation d'épaisseur relative de 0,03% pour les directions de propagation comprises entre $\pm30$ et $\pm40°$

Selon une variante de l'invention, le résonateur comporte deux réseaux de réflecteurs constitués de traits métalliques. L'un au moins des deux réseaux comporte localement quelques réflecteurs réalisés avec un métal différent. Typiquement lorsque l'ensemble des réflecteurs est en aluminium, les quelques électrodes mises en jeu pour modifier la résonance parasite peuvent être par exemple en aluminium avec un léger dopage de cuivre, ce dopage étant susceptible de modifier les propriétés de réflectivité selon son importance. On peut utiliser également du cuivre, la masse volumique étant dans ce cas substantiellement supérieure. On peut également déposer sur certaines électrodes un film de métal supplémentaire (Cr, Au, Ti, Pt, etc.), faisant varier notablement la réflectivité sans trop affecter la vitesse de propagation ni les pertes acoustiques. Le métal et son épaisseur sont choisis afin d'obtenir une modification sensible de la directivité sans trop affecter la vitesse du mode par rapport au reste du réseau).

Une alternative à cette variante réside dans la possibilité de faire varier localement la passivation de quelques unités de traits réflecteurs au sein d'au moins un des deux réseaux réflecteurs, l'opération de passivation étant une opération finale classique de protection des composants à ondes de surface

## Revendications

1.  Résonateur à ondes acoustiques de surface réalisé sur un substrat de coupe avec des axes de propagation pour lesquels il existe une directivité non nulle et comportant au moins un transducteur central (Tc) présentant un axe central perpendiculaire à l'axe de propagation de l'onde acoustique, un premier réseau de réflecteurs ($R_1$) et un second réseau de réflecteurs ($R_2$), lesdits réseaux étant situés de part et d'autre dudit transducteur, les deux réseaux de réflecteurs ayant des configurations non symétriques par rapport à l'axe central dudit transducteur central, caractérisé en ce que le premier et/ou le second réseaux de réflecteurs présentent sur une portion d'unités de réflecteurs, une variation de périodes desdits réflecteurs, lesdites portions des réseaux respectifs étant différentes de manière à conférer lesdites configurations non symétriques.

2.  Résonateur à ondes acoustiques de surface selon la revendication 1, **caractérisé en ce que** le premier réseau de réflecteurs présentant une première distance ($d_1$) de séparation par rapport au transducteur, le second réseau de réflecteurs présentant une seconde distance ($d_2$) de séparation par rapport au transducteur, les première et seconde distances de séparation correspondant respectivement à la distance entre une extrémité du premier réseau de réflecteurs et une première extrémité du transducteur et à la distance séparant une extrémité du second réseau de réflecteurs et la seconde extrémité du transducteur, lesdites distances de séparation étant différentes.

3. Résonateur à ondes acoustiques de surface selon l'une des revendication 1 ou 2, **caractérisé en ce que** le premier et/ou le second réseau de réflecteurs comportent une à plusieurs centaines de réflecteurs et présentent sur environ un dixième d'unités de réflecteurs, une variation de périodes desdits réflecteurs.

4. Résonateur à ondes de surface selon l'une des revendications 1 à 3, **caractérisé en ce que** la variation de période par rapport à la période des réseaux de réflecteurs est de l'ordre de quelques pour mille.

5. Résonateur à ondes acoustiques de surface selon l'une des revendications 1 à 4, les réflecteurs étant constitués de traits métalliques, la première série et/ou la seconde série de réflecteurs présentent sur une portion d'unités de réflecteurs, une variation d'épaisseur desdits traits.

6. Résonateur à ondes acoustiques de surface selon l'une des revendications 1 à 4, les réflecteurs étant constitués de traits métalliques, la première série et/ou la seconde série de réflecteurs présente sur une portion d'unités de réflecteurs, une variation de nature de métal.

7. Résonateur à ondes acoustiques de surface selon la revendication 1, **caractérisé en ce que** les réflecteurs étant constitués de traits métalliques recouverts d'une couche de passivation, le premier réseau et/ou le second réseau de réflecteurs présentent sur une portion d'unités de réflecteurs, une variation de l'épaisseur de ladite couche de passivation ou une variation de nature de passivation.

**Claims**

1. A surface acoustic wave resonator realised on a cut substrate with axes of propagation for which non-zero directivity exists and comprising at least one central transducer (Tc) having a central axis perpendicular to the axis of propagation of the acoustic wave, a first array of reflectors ($R_1$) and a second array of reflectors ($R_2$), said arrays being located either side of said transducer, said two arrays of reflectors having non-symmetric configurations relative to the central axis of said central transducer, **characterised in that** said first and/or said second arrays of reflectors have a periodic variation of said reflectors over a portion of reflector units, said portions of said respective arrays being different so as to confer said non-symmetric configurations.

2. The surface acoustic wave resonator according to claim 1, **characterised in that** said first array of reflectors has a first distance ($d_1$) of separation relative to said transducer, said second array of reflectors has a second distance ($d_2$) of separation relative to said transducer, said first and second distances of separation respectively corresponding to the distance between one end of said first array of reflectors and a first end of said transducer and the distance separating one end of said second array of reflectors and the second end of said transducer, said distances of separation being different.

3. The surface acoustic wave resonator according to claim 1 or 2, **characterised in that** said first and/or said second array of reflectors comprise one or more hundreds of reflectors and exhibit, on approximately one tenth of reflector units, a periodic variation of said reflectors.

4. The surface acoustic wave resonator according to any one of claims 1 to 3, **characterised in that** the periodic variation relative to the period of the arrays of reflectors is of the order of a few per thousand.

5. The surface acoustic wave resonator according to any one of claims 1 to 4, said reflectors being constituted by metal lines, the first series and/or the second series of reflectors have a variation in the thickness of said lines over a portion of reflector units.

6. The surface acoustic wave resonator according to any one of claims 1 to 4, said reflectors being constituted by metal lines, said first series and/or said second series of reflectors have a variation in the type of metal over a portion of reflector units.

7. The surface acoustic wave resonator according to claim 1, **characterised in that**, since said reflectors are constituted by metal lines covered with a passivation layer, said first array and/or said second array of reflectors have a variation in the thickness of said passivation layer or a variation in the type of passivation over a portion of reflector units.

**Patentansprüche**

1. Resonator für akustische Oberflächenwellen, ausgeführt auf einem geschnittenen Substrat mit Ausbreitungsachsen, für die eine Direktivität von ungleich null existiert, und mit wenigstens einem mittleren Wandler (Tc) mit einer mittleren Achse lotrecht zur Ausbreitungsachse der akustischen Welle, einem ersten Netz von Reflektoren ($R_1$) und einem zweiten Netz von Reflektoren ($R_2$), wobei sich die Netze auf beiden Seiten des Wandlers befinden, wobei die beiden Reflektornetze nichtsymmetrisch in Bezug auf die mittlere Achse des mittleren Wandlers konfiguriert sind, **dadurch gekennzeichnet, dass** das erste und/oder das zweite Reflektornetz auf einem Abschnitt von Reflektoreinheiten eine periodische Variation der Reflektoren aufweist/-en, wobei sich die Abschnitte der jeweiligen Netze so unterscheiden, dass sie die nichtsymmetrischen Konfigurationen verleihen.

2. Resonator für akustische Oberflächenwellen nach Anspruch 1, **dadurch gekennzeichnet, dass** das erste Reflektornetz einen ersten Trennabstand ($d_1$) in Bezug auf den Wandler aufweist, das zweite Reflektornetz einen zweiten Trennabstand ($d_2$) in Bezug auf den Wandler aufweist, wobei der erste und der zweite Trennabstand jeweils dem Abstand zwischen einem Ende des ersten Reflektornetzes und einem ersten Ende des Wandlers und dem Abstand entsprechen, der ein Ende des zweiten Reflektornetzes und das zweite Ende des Wandlers trennt, wobei die Trennabstände unterschiedlich sind.

3. Resonator für akustische Oberflächenwellen nach Anspruch 1 oder 2, **dadurch gekennzeichnet, dass** das erste und/oder das zweite Reflektornetz ein bis mehrere hundert Reflektoren umfassen und auf etwa einem Zehntel der Reflektoreinheiten eine periodische Variation der Reflektoren aufweisen.

4. Resonator für akustische Oberflächenwellen nach einem der Ansprüche 1 bis 3, **dadurch gekennzeichnet, dass** die periodische Variation in Bezug auf die Periode der Reflektornetze in der Größenordnung von einigen pro tausend liegt.

5. Resonator für akustische Oberflächenwellen nach einem der Ansprüche 1 bis 4, wobei die Reflektoren von Metalllinien gebildet werden, wobei die erste Serie und/oder die zweite Serie von Reflektoren auf einem Abschnitt von Reflektoreinheiten eine Dickenvariation der Linien aufweisen.

6. Resonator für akustische Oberflächenwellen nach einem der Ansprüche 1 bis 4, wobei die Reflektoren von Metalllinien gebildet werden, wobei die erste Serie und/oder die zweite Serie von Reflektoren auf einem Abschnitt von Reflektoreinheiten eine Variation der Art des Metalls aufweisen.

7. Resonator für akustische Oberflächenwellen nach Anspruch 1, **dadurch gekennzeichnet, dass** die Reflektoren von Metalllinien gebildet werden, die mit einer Passivierungsschicht bedeckt sind, wobei das erste Netz und/oder das zweite Netz von Reflektoren auf einem Abschnitt von Reflektoreinheiten eine Variation der Dicke der Passivierungsschicht oder eine Variation der Art der Passivierung aufweisen.

FIG.1

FIG.2

FIG.3

FIG.4

FIG.5a

FIG.5b

Quartz ST (YXlt)/42.75°/ψ

FIG.6

FIG.7a

FIG.7b

FIG.7c

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2864618